# EUROPEAN PATENT SPECIFICATION

(11) **EP 2 992 538 B1**
(45) Date of publication and mention of the grant of the patent: **04.10.2017**
(21) Application number: 14723998.2
(22) Date of filing: 25.04.2014
(51) Int. Cl.: H01F 38/20

(54) **HV INSTRUMENT TRANSFORMER**
HOCHSPANNUNGSINSTRUMENTENTRANSFORMATOR
TRANSFORMATEUR D'INSTRUMENT HV

(30) Priority: 29.04.2013 EP 13460024
(43) Date of publication of application: 09.03.2016
(73) Proprietor: ABB Schweiz AG, 5400 Baden (CH)
(72) Inventor: BANASZCZYK, Jedrzej, PL- 30-611 Krakow (PL); CZYZEWSKI, Jan, PL-30-376 Krakow (PL); ADAMCZYK, Bartlomiej, PL-34-735 Niedzwiedz (PL); WYSOCKI, Wojciech, PL-31-271 Krakow (PL); BACHORZ, Lukasz, PL-64-330 Opalenica (PL); GRYSZTAR, Pawel, PL-38-440 Iwonicz Zdroj (PL); TZAVALAS, Spiros, 5426 Lengnau, CH-Aargau (CH); KRUESI, Urs, CH-8542 Wiesendangen (CH); MEIER, Patrick, CH-5603 Staufen (CH); SJOGREN, Lars, S-77194 Ludvika (SE)
(74) Representative: Chochorowska-Winiarska, Krystyna
(86) International application number: PCT/EP2014/001131
(87) International publication number: WO 2014/177268

(56) References cited:
- WO-A1-2009/146569
- CH-A- 318 300
- DE-A1- 3 702 782

## Description

### BACKGROUND

The subject of invention is a high-voltage (HV) instrument transformer based on a new type of combined dry insulation system.

Currently, most high-voltage instrument transformers, both current transformers and voltage transformers are electrically insulated by oil-impregnated paper.

The current transformers are built in top-core or hair-pin technologies.

The hair-pin construction of high-voltage current transformers comprises a long HV conductor with a U shape, around which the insulation paper is wrapped and immersed in oil. The insulation typically comprises a field grading structure consisting of electrically conducting layers inserted between the layers of the paper wrapping. The secondary winding of the transformer is arranged around the insulated conductor at the bottom of the U shape. The very long conductor of the primary winding of the hair-pin type is a disadvantage, as due to the electric resistance of the conductor the heat is generated and limits significantly the current rating of the transformer that can be obtained.

The top-core construction of a high-voltage current transformer typically consist of a support insulator, a metallic head housing carried by the support insulator and a bushing enclosed in the head housing, the bushing running through the iron cores and the secondary windings of the transformer. The primary winding consists of a straight HV conductor passing through the opening of the bushing. The conductor of the primary winding is short and can easily be made in large diameter and thus small electric resistance and be characterized by small thermal losses which allow for much higher current ratings than those of the hair-pin types.

The most common electrical insulation system of the top-core current transformer is made in oil-impregnated paper technology. The insulation paper is wrapped around the corresponding high-voltage and grounded construction elements or stacked from precut sheets and inserted in the space designed to carry the electric stress. The whole insulation paper system, including that in the head housing and in the support insulator, is subsequently dried and immersed in transformer oil.

It is important that the dimension and the weight of the top part of the transformer with its bushing, iron cores, windings and insulating materials can be minimized to reduce the mechanical stresses to which the relatively high support insulator is exposed when loaded dynamically, e.g. in case of strong wind or an earthquake.

One of the methods to reduce the weight of the head of the transformer is to provide the insulation system with a possibly uniform electric field, thus minimizing the insulation distances and consequently the physical size of the head. This can be done with the capacitive field grading which is typically realized using electrically conductive sheets inserted between the layers of insulating paper. An example of capacitive field grading leading to the reduction of the size of is given in the patent US4117437. The capacitive field grading system consists of concentric cylindrical electrically conducting sheets arranged around the conductor of the primary winding of the transformer and a number of flat parallel conductive rings with annular openings arranged at both sides of the field grading structure consisting of the cylindrical sheets.

The solution presented in patent PL195878B1 discloses the insulation of the toroidal secondary winding of the current transformer, placed in the head tank of a combined current- and voltage transformer, with a layer of solid-state insulating material, epoxy resin, arranged around a metal shield of the winding. The so formed insulation system is immersed in oil. The application of the layer of epoxy insulation, with the dielectric strength larger than oil, leads to some decrease of the insulation distances. The lack of capacitive grading in the structure limits however this decrease significantly.

The construction of a high-voltage inductive voltage transformer typically consist of a column insulator mounted on top of a grounded tank and having a metallic high-voltage head electrode at its top. The HV lead is led down through the column insulator to the primary winding of the transformer placed in the grounded tank. The electrical insulation of the column insulator and the primary winding is made of paper impregnated with transformer oil.

To compensate for the thermal shrinkage and expansion of oil, both in the current transformer and in the voltage transformer, a part of the volume of oil is included in the area which is not electrically stressed and serves only as the expansion compensation volume. This expansion volume can be contained in a separate expansion tank on top of the head housing. Such solution is adopted in the transformer described in PL195878B1. Systems with moderate volume of oil can use an elastic diaphragm included in the head tank, as described e.g. in US4117437.

In each case the additional amount of oil in the head of the transformer increases its weight and in consequence leads to the higher mechanical stress exerted on the support insulator when loaded dynamically. Application of oil in the insulation system causes also a risk of leakages and environmental pollution and oil is typically not fire resistant. Those disadvantages can be eliminated by using dry, liquid-free insulation in the head and the column of the transformer.

From the GB742554 patent decsriprion there is known a dry instrument transformer which has current transformer windings at least partialy embeded in a closed end of a hollow insulating member of tubular shape made of synthetic thermosetting resin. The insulating member has potential gradient control means which are at least partly embedded in the walls of the insulating member. The outer surface of the closed end of the insulating member is provided with electrically conducting coating which is connected to the primary winding of the current transformer. Weathersheds are provided wich may be integral with the insulating member. The potential gradient control means comprises overlapping cylindrical condenser plates embedded in the walls of the insulating members. The insulating member is preferably manufactured by a centrifugal casting process forming the subject of Specification GB 742 413. In this solution the current transformer core is a ring embedded in the head of the insulating member. The HV primary winding is reduced to a rod passing through the transformer core. The low-votage (LV) secondary winding is wound around this core and is embedded with it in the insulating material. The radial electric field in the vicinity of the rod is very high, much higher than the average field between the rod and the secondary winding. Due to this nonuniformity of the field the distances beteween those LV and HV elements must be very large to guarantee the necessary dielectric strength of the insulation system. The potential gradient control means in the column of the transformer, which are placed only close to the external surface of the column, provide only the grading of the axial field, while the radial field in the column is ungraded. The resulting high electric field around the secondary winding leads in the top part of the apparatus causes the radial field to be highly non-uniform requiring a large radial insulation distance. All these requirements contribute to a substantial increase of the dimensions of the apparatus.

The GB742554 patent decsriprion discloses also a dry voltage transformer in which the primary winding is placed vertically along the column insulator close to its outer surface, providing in the same time the grading of the axial electric field along the column. The radial electric field in the column is ungraded and thus, especially in the area close to the head of the transformer, strongly non-uniform, resulting in a requirement of large insulation distances and large diameter of the column.

The resulting large size of the instrument transfomer is the main disadvantage of the solution described.

Apart of the large stresses when dynamically loaded, the large size of the instrument transformer causes also difficulties in manufacturing of the transformer, as due to the chemical and thermal shrinkage during the process of hardening of the synthetic resins, as well as the exothermic nature of the process and low thermal conductivity of the resins, the mechanical stresses generated in the hardening process increase substantially with increasing size of the hardened structure causing a risk of producing voids or cracks inside the insulation structure. This causes a size limitation, which, in turn limits the voltage level at which the instrument transformer can be applied.

From patent application WO 2009/146569 there is known a high-voltage transducer having a form of a current transformer or a voltage transformer. The current transformer has an elastic insulation placed in a metal encapsulation. The elastic insulation is made of a flexible and compressible silicone gel material. The current transformer is provided with a column comprising a column insulating body for electric insulation of leads of a secondary winding assembly of the transformer. The voltage transformer has an elastic insulation placed in a grounding housing. The voltage transformer is provided with a column comprising a column insulating body for electric insulation of a lead of primary winding of the transformer. The column insulating body is in contact with the elastic insulation which is made of the same material as for the current transformer. For the voltage transformer the elastic insulation tightly adheres to matching outer surfaces of the primary winding, column insulating body and to the inner surface of the grounding housing. For the current transformer the insulation tightly adheres to matching outer surfaces the column insulating body, a winding shield and to the inner surface of the metal encapsulation. The high-voltage instrument transducer (transformer) presented in WO 2009/146569 has a form of a current transformer CT or a voltage transformer VT. The current transformer CT has an elastic insulation member in a conductive encapsulation and is provided with a column comprising a column insulating body for electric insulation of leads of a secondary winding assembly. The voltage transformer VT has an elastic insulation member and is provided with a column comprising a column insulating body for electric insulation of a lead of primary winding. Both column insulating bodies are in contact with the insulating members of CT or VT transformers, respectively. Both columns of CT and VT transformers have external insulators. For the voltage transformer VT the insulating member is made of the same material as for the current transformer CT. For the voltage transformer VT the insulating member tightly adheres to matching outer surfaces of the primary winding, column insulating body and to the inner surface of the conductive encapsulation. For the current transformer CT the elastic insulation member tightly adheres to matching outer surfaces the column insulating body, a winding shield and to the inner surface of the conductive encapsulation.

### SUMMARY

The essence of a HV instrument transformer according to the invention, having a form of a current transformer CT or a voltage transformer VT, is that the current transformer has a head insulating body having a form of a bushing for electrical insulation of the secondary winding assembly from the primary winding conductor, the head insulating body being placed within a conductive encapsulation and being in contact with the insulating member, which is made of an elastic conformable material which tightly adheres to matching outer surfaces of the head insulating body, the column insulating body, a winding shield and to the inner surface of the conductive encapsulation of the current transformer, whereas for the voltage transformer the insulating member is made of the same material as for the current transformer and the insulating member tightly adheres to matching outer surfaces of the primary winding, column insulating body and to the inner surface of the conductive encapsulation. The conductive encapsulation is made of electrically conductive polymer or elastomer material.

Preferably the column of the current or the insulating column of the voltage transformer has a slit which is filled with the insulating member.

Preferably the winding shield is made of metal or electrically conductive polymer or elastomer material.

Alternatively the elastic conformable material of the insulating member is a silicone elastomer or a gel chosen from silicone, polyurethane gel or urethane modified epoxy gel.

Preferably the conductive encapsulation is made of electrically conductive elastomer, preferably conductive silicone rubber.

Preferably the winding shield is made of metal, electrically conductive polymer material or electrically conductive elastomer material, preferably conductive silicone rubber.

Preferably the head insulating body, the column insulating body of the current transformer CT and the column insulating body of the voltage transformer VT have a capacitive field grading system with field-grading layers and in each field grading system the field-grading layers are spaced from each other by insulating material made of paper impregnated with hardenable resin.

Alternatively the head insulating body and the column insulating body have a capacitive field grading system with field-grading layers and in each field grading system the field-grading layers are spaced from each other by insulating material made of polymer fibers impregnated with hardenable resin.

Preferably the hardenable resin comprises epoxy resin and an inorganic filler material.

Preferably the external insulator is made of a silicon elastomer directly molded on the column insulating body.

Alternatively the high-voltage instrument transformer has the external insulator which is provided with a stiff hollow cylinder, overmolded with weather sheds made of polymer or elastomer material.

Preferably the high-voltage instrument transformer has the external insulator which is made of porcelain material.

### ADVANTAGES

The instrument transformer in the form of the current transformer comprises two insulating elements with capacitive field grading systems providing the grading of both the radial and the axial field in those elements. The substantially uniform radial electric field in the insulating elements allows for effective exploiting of the field strength of the insulating material applied and consequently for minimizing the diameters of the elements. The space bridging the two capacity graded elements, as well as the volume in the current transformer head, is filled with an elastic conformable insulating member, having the ability to accommodate the thermal shrinkage or expansion of the transformer structure.

The instrument transformer in the form of the voltage transformer comprises one insulating element with capacitive field grading system providing the grading of both the axial and radial field in the element. The space bridging the capacitively graded element, the dry insulation of the primary winding is filled with an elastic conformable insulating member, having the ability to accommodate the thermal shrinkage or expansion of the transformer structure.

The small size and the simple shape of the capacitively graded elements allows for manufacturing those using hardenable resins without generating large mechanical stresses or producing voids or cracks. The material of the insulating member can be filled into the appropriate space in a separate process so as it adheres firmly to the matching elements of the construction. The elasticity and conformability of the insulating member allows for maintaining this adhesion in the broad span of operating temperatures of the apparatus as the insulating member can deform or change its volume without generating substantial mechanical stresses thus compensating for the differences in thermal expansion of materials used in the apparatus.

The instrument transformer is compact and light-weight. Also the new instrument transformer allows to reduce the mechanical stresses, to which the relatively high column of the current transformer or insulator column of the voltage transformer is exposed when loaded dynamically, e.g. in case of strong wind or an earthquake.

The dry, liquid-free construction of the instrument transformer prevent in the same time the risks of leakages or fire hazards.

### DETAILED DESCRIPTION

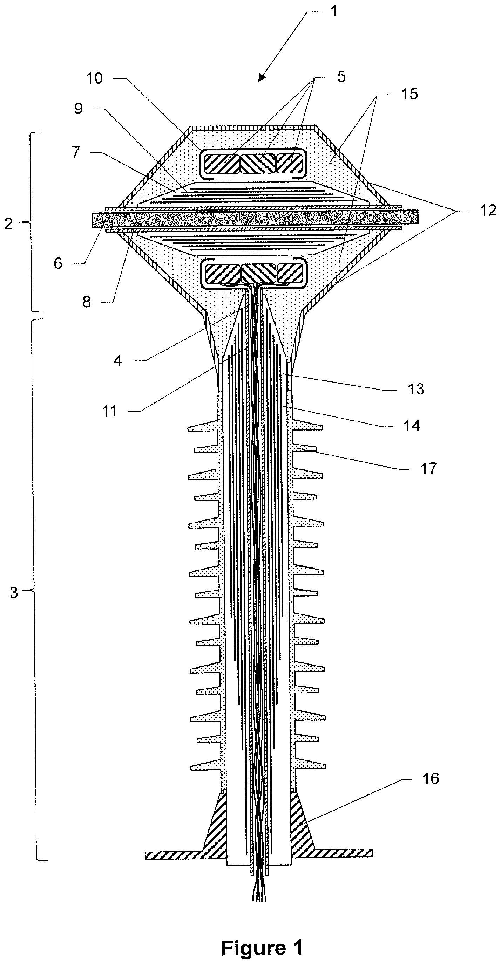

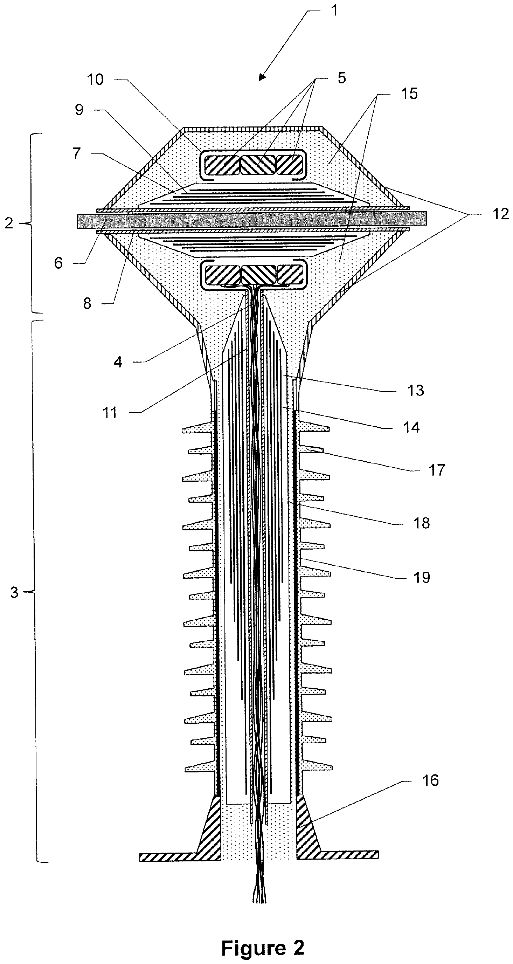

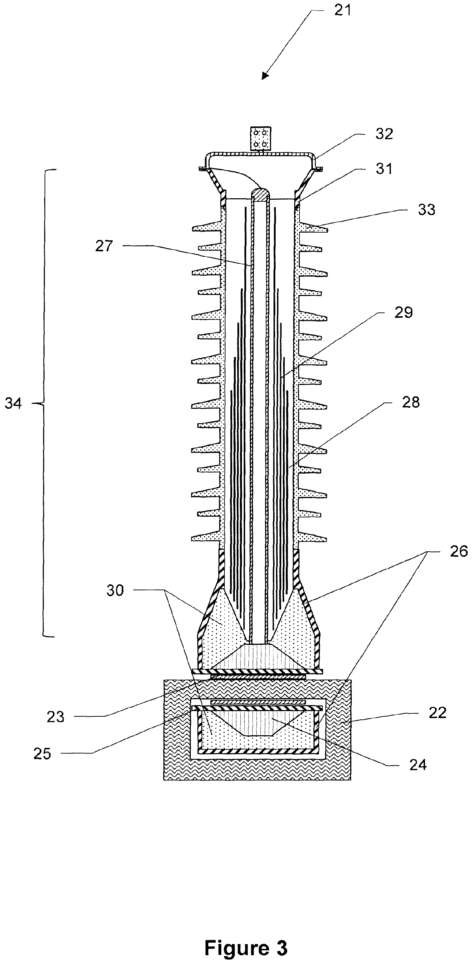

The HV instrument transformer according to the invention is presented on the drawing in a cross-section view, where fig. 1 shows current transformer CT in a first embodiment, fig.2 - current transformer CT in a second embodiment, fig.3 - voltage transformer VT in a first embodiment, fig.4 - voltage transformer VT in a second embodiment, fig.5 - voltage transformer VT in a third embodiment.

The instrument transformer has a form of a current transformer 1 CT or a voltage transformer 21 VT. Both current and voltage transformers can also be carried out as a combined instrument transformer what is not presented on the drawing.

The current transformer CT 1 comprises a transformer head 2 supported by the column 3 of the transformer. The column 3 has a form of an elongated tube mounted on a grounded box, not shown in the drawing, which contains terminals for the secondary winding leads 4 running from at least one secondary winding assembly 5 located inside the head 2 of the transformer. The windings can be arranged, in a known manner, around annular iron cores, or can be made as a Rogowski coils, without a magnetic core. The primary winding, consisting of a primary conductor 6, runs through a head insulating body 7 in the form of a hollow cylinder constructed as a capacitor bushing and extending through the head 2. The head insulating body 7 can be built-up around a primary conductor tube 8, or can be built-up directly around the conductor 6. The head insulating body 7 has a field-grading layer system which is built-up by winding layers of a sheet-like spacer insulating material onto the tube 8, or directly onto the conductor 6, and inserting electrically conductive field-grading layers 9 of head insulating body 7 with outwardly diminishing axial length between the spacer material turns. The resulting capacitor bushing forming the head insulating body 7 is then impregnated with hardenable resin and hardened. The secondary winding assembly 5 is arranged around the central portion of the head insulating body 7. The winding assembly 5 is enclosed at the sides and at the outer surface by an electrically conductive winding shield 10 which, together with the outermost of the layers 9 in head insulating body 7, is electrically connected to ground through a current transformer lead tube 11, passing centrally through the column 3. The head 2 is covered from outside by an electrically conductive encapsulation 12. The innermost of the layers 9 in the head insulating body 7 is electrically connected to the tube 8 and to the encapsulation 12. The primary conductor 6 is suitably connected to the encapsulation 12 only at one side, so as to prevent part of the primary current from flowing through the encapsulation 12. The primary winding can also be made with more turns, what is not shown in the drawing, with its conductor passing twice or more times through the head insulating body 7 and returning back through the space external to the conducive encapsulation 12. Secondary winding leads 4 are passed through the tube 11. The tube 11 in the column 1 is surrounded by a column insulating body 13 with field grading layers 14 of column insulating body. The column insulating body 13 is made using the similar technique as that used to manufacture the head insulating body 7. The outermost field-grading layer is electrically connected to the encapsulation 12. The innermost field-grading layer is suitably grounded by being connected to the tube 11.

In one embodiment of the invention concerning the current transformer CT the space inside the encapsulation 12 and outside the head insulating body 7, the winding shield 10 and the top part of the column insulating body 13 is filled with an insulating member 15 tightly adhering to the surfaces of the latter components. The insulating member 15, the winding shield 10 and the encapsulation 12 are made using such materials or material combinations that no substantial mechanical stresses are released during thermal shrinkage or expansion of those elements. This is realized by application of elastic conformable materials to manufacture at least one of these components and/or application for pairs of adhering components materials of substantially identical thermal expansion coefficients. The column 3 is fixed at its bottom to the support flange 16 and is coated by an external insulator 17 providing suitable creepage length for the insulator.

In other embodiment of the invention concerning the current transformer CT the column insulating body 13 is placed in the column 3 is such a way that between an internal surface of the external insulator 17 and an external surface of the column insulating body 13 there is a slit 18. The slit 18 is filled with an elastic conformable material, for example the same material as that used for the insulating member 15.

In the first embodiment of the current transformer CT the external insulator 17 is provided with weather sheds and is carried out as a silicone elastomer directly molded on the column insulating body 7. In the second embodiment the external insulator 17 has a form of a hollow cylinder 19 prefabricated with flange 16 and covered by the a silicone elastomer molded on the hollow cylinder 19. Alternatively, in the second embodiment of the current transformer CT the external insulator 17 can be made of a ceramic material firmly mounted to the flange 16.

Alternatively, in both embodiments, especially if the conductive encapsulation 12 is made of an elastic material, the head 2 of the current transformer can be provided with an additional metal enclosure, not shown in the drawing, surrounding the conductive encapsulation 12 and suitably electrically connected to the primary winding conductor 6 on its one side.

In both the first and the second embodiment the part of of the conductive encapsulation 12 adjacent to the external insulator 17 can be made in a form of a metallic flange firmly mounted to the column insulating body 13 or to the external insulator 17.

The voltage transformer VT 21 comprises a magnetic core 22 with a secondary winding 23 and primary winding 24. The primary winding 24 is made as a solid block, wound in layers on a primary winding tube 25 to an elongated shape and is impregnated with a hardenable material, for example based on epoxy resin, and hardened. Alternatively the primary winding 24 can be wound on a mandrel which is withdrawn after hardening the resin which results in a winding having a form of a solid block without the tube, which embodiment is not shown in the drawing. The primary winding 24 is placed inside a conductive encapsulation 26 of voltage transformer 21. The conductive encapsulation 26 is grounded. The outer end of the primary winding 24 is connected with a primary winding lead 27 wich is placed inside the column insulating body 28 having a form of a capacitor bushing. The inner end of the primary winding 24 is grounded. The column insulating body 28 has a field-grading layer system which is built-up by winding layers of a sheet-like spacer insulating material on the lead 27 having a form of a metal tube, and inserting electrically conductive field-grading layers 29 of column insulating body insulating body 28 has a field-grading layer system which is built-up by winding layers of a sheet-like spacer insulating material on the lead 27 having a form of a metal tube, and inserting electrically conductive field-grading layers 29 of column insulating body with outwardly diminishing axial length between the spacer material turns. The resulting capacitor bushing forming the column insulating body 28 is then impregnated with hardenable resin and hardened. The outermost field-grading layer of the column insulating body 28 is electrically connected to the conductive encapsulation 26. The innermost field-grading layer is electrically connected to the lead 27.

In one of the embodiments of the voltage transformer VT the space inside the encapsulation 26 and outside the primary winding 24 and the bottom part of the column insulating body 28 is filled with an insulating member 30 tightly adhering to the surfaces of the latter components. The insulating member 30 and the conductive encapsulation 26 are made using such materials or material combinations that no substantial mechanical stresses are released during thermal shrinkage or expansion of those elements. This is realized by application of elastic conformable materials to manufacture at least one of those components.

The column insulating body 28 is fixed at its top to the top flange 31 which is closed by the top cover 32. The lead 27 is electrically connected to the flange 31 and to the cover 32, which together form the HV electrode of the voltage transformer 21. Alternatively the HV electrode can be made in many different ways, for example being formed by the top end of the lead 27 directly protruding from the column insulating body 28, which is not shown in the drawing. The column insulating body 28 is placed in an external insulator 33 providing suitable creepage length for the insulator.

In the second embodiment of the voltage transformer VT 21 the column insulating body 28 is placed inside the column 34 of voltage transformer in such a way that between the internal walls of the external insulator 33 and the external surface of the insulating body 28 there is a slit 35 which is filled with an elastic conformable material, for example the same material as that being used for the insulating member 30. The lower part of the conductive encapsulation 26 is placed in an additional container 36 which forms a base support of the voltage transformer. The upper part of the conductive encapsulation 26, adjacent to the external insulator 33, can be made in a form of a metallic flange, which is not shown in the drawing, firmly attached to the column insulating body 28 or to the external insulator 33 from its top side and to the container 36 in its bottom part.

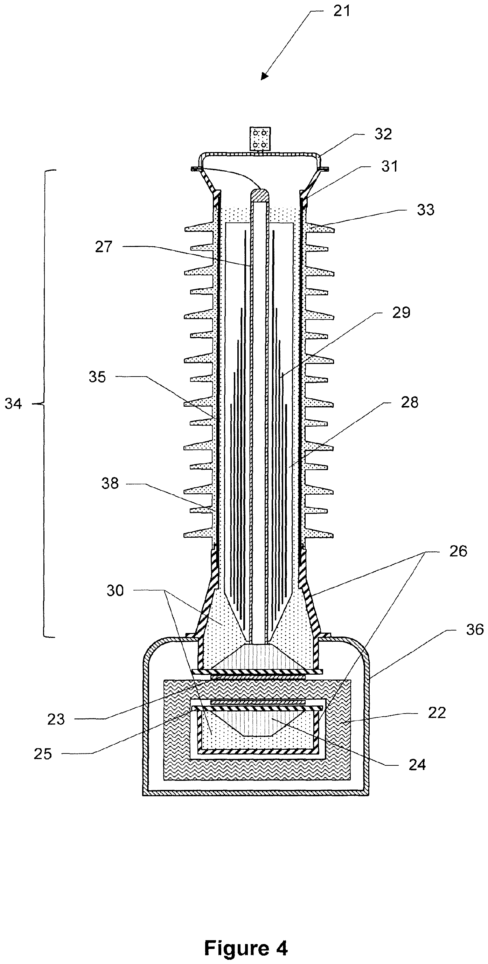

In the third embodiment of the invention the voltage transformer 21 VT is built-up similarly as the voltage transformer from fig.4 but with the secondary winding 23' and the core 22 being embedded in the insulating member 30 within the conductive encapsulation 26. The conductive encapsulation 26 in this embodiment is formed by a flange 37 and the container 36.

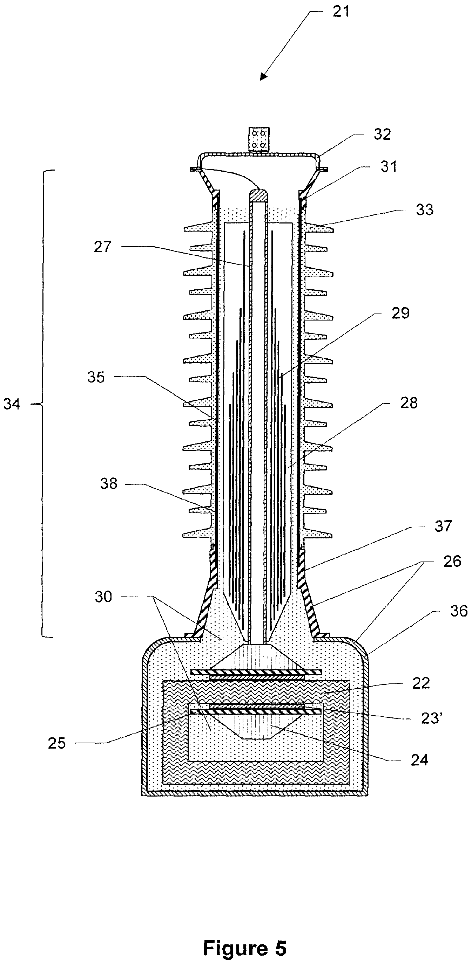

In the first embodiment of the voltage transformer VT the external insulator 33 is provided with weather sheds and carried out as a silicone elastomer directly molded on the column insulating body 28. In the second and the third embodiment of the voltage transformer VT the external insulator 33 is provided in a form of a hollow cylinder 38 prefabricated with the flange 31 and/or 37 and covered by the a silicone elastomer molded on the hollow cylinder 38. Alternatively, in the second and third embodiment of the voltage transformer VT shown in fig. 4 and fig. 5 the external insulator 33 can be made of a ceramic material firmly mounted to the flanges 31 and/or 37.

The winding shield 10 can also be an integral part of the winding assembly 5, which is not shown in the drawing, being for example formed by the external layer of tightly wound wires of the secondary winding of the current transformer.

In all of the embodiments of the invention elastic conformable electrically insulating material is used for the insulating member 15 or 30, e.g. a silicone elastomer, such as Liquid Silicon Rubber LSR, or silicone gel, polyurethane gel, utherane modified epoxy gel can be used. As an exemplary matrial one of the following materials can be chosen: Silicone gel Q-Gel 331 from ACC Silicones LTD, Polyurethane gel MPP-V37A from Northstar Polymers LLC, Urethane modified epoxy gel-Polymer system super gel 9 from Master Bond Inc.

In the case as above the conductive encapsulation 12 of CT or the conductive encapsulation 26 of VT is made of an elastic electrically conductive material, for example a conductive elastomer material, e.g. silicone elastomer filled with carbon black.

In all the embodiments of the invention where the elastic comformable electrically insulating material is used for the insulating member 15 of CT or the insulating member 30 of VT, the winding shield 10 can be made of a rigid or elastic electrically conductive material. In the all embodiments of the invention the head insulation body 7 and the column insulating body 13 of CT or the column insulating body 28 of VT can be made in two techonologies known as RIP (Resin Impregnated Paper) and RIS (Resin Impregnated Synthetics) using as an impregnating material a hardenable resin, e.g. epoxy resin, hardened after impregnation.

In the RIP techology the primary conductor tube 8, the current transformer lead tube 11 or the primary winding lead 27 is wrapped with creped paper, further referred to as spacer, not presented on the drawing. Metallic layers 9, 14 or 29 are inserted inbetween the layers of that spacer at appropriate radial distances from the tube 8 or 11 or from the primary winding lead 27. The spacer has the function to hold the metallic layers in appropriate distance around the conductive tubes 8 and 11 or lead 27. The metallic layers have the function to control the electric field - radial in the space between the layers and axial at the outer surfaces of the head insulation body 7, the column insulating body 13 or 28. Afterwards, when the winding of the crepe paper is accomplished, the body is dried and subsequently impregnated under vacuum with a curable polymer resin. The polymer resin flows through the porous paper layers to impregnate the whole insulating body. Low-viscosity, unfilled polymer resins can be used for the impregnation, typically heat curable, epoxy resins. After impregnation, the resin is cured and machined to the final shape of the insulating body.

In the RIS technology the primary conductor tube 8, the current transformer lead tube 11 or the primary winding lead 27 is wrapped with a spacer made of polymer fabric. Metallic layers 9, 14 or 29 are inserted at the appropriate positions similarly as in the RIP technolgy. Depending on the porosity of the spacer material, particle filled impregnation resins can also be used for the impregnation process. The preferred fillers are typically Al2O3, but also other kinds other fillers, as for instance SiO2, TiO2, AIN or chopped glass fibres can be used. The use of a filled impregnation resin improves the thermal conductivity of the material and reduces heat release and srhinkage during the curing process so that the insulating bodies can be cast directly to their final shape.

Alternatively, the column insulating body 13 of CT or the column insulating body 28 of VT can be wound on a tube made of an electrically insulating material and the lead 27 can be made as a wire running through the tube, which is not shown in the drawing. The innermost of the field grading layers 14 or 29 is then suitably connected to one of the leads 4 which is grounded or to the lead 27, respectively. The column insulating body 13 or 28 can also be wound on a mandrel which is withdrawn after the hardening of the resin resulting in the insulating body without the tube which is not shown in the drawing. Similar constructions can also be used for the head insulating body 7 with the appropriate electrical connection of the innermost of the field grading layers 9 to the primary winding conductor 6.
1 - current transformer
2 - transformer head
3 - column of current transformer
4 - secondary winding leads
5 - winding assembly
6 - primary conductor
7- head insulating body
8 - primary conductor tube
9 -field-grading layers of head insulating body
10 - winding shield
11 - current transformer lead tube
12 - conductive encapsulation of current transformer
13 - column insulating body of current transformer
14 - field-grading layers of column insulating body of current transformer
15 - insulating member of current transformer
16 - support flange
17 - external insulator of current transformer
18 - slit in column of current transformer
19 - hollow cylinder of current transformer
21 - voltage transformer
22 -core of voltage transformer
23 - secondary winding outside the conductive encapsulation
23' - secondary winding inside the conductive encapsulation
24 - primary winding of voltage transfomrer
25 - primary winding tube
26 - conductive encapsulation of voltage transformer
27 - primary winding lead
28 - column insulating body of voltage transformer
29 -field-grading layers of column insulating body of voltage transformer
30 -insulating member of voltage transformer
31 - top conductive flange
32 - top cover
33 - external insulator of voltage transformer
34 -column of voltage transformer
35 - slit in column of voltage transformer
36 - container
37 - bottom flange of voltage transformer
38 - hollow cylinder of voltage transformer

## Claims

1. High- voltage instrument transformer having the form of a current transformer CT (1) or a voltage transformer VT (21) in which the current transformer (1), having an elastic insulation member (15) in a conductive encapsulation (12), is provided with a column (3) comprising a column insulating body (13) for electric insulation of leads (4) of a secondary winding assembly (5), the voltage transformer (21), having an elastic insulation member (30), is provided with a column (34) comprising a column insulating body (28) for electric insulation of a lead (27) of primary winding (24), wherein the column insulating body (13) of CT or the column insulating body (28) of VT is in contact with the insulating member (15) of CT or the insulating member (30) of VT , respectively, wherein the column (3) of CT or the column (34) of VT has an external insulator (17) of CT or an external insulator (33) of VT and whereas for the voltage transformer VT (21) the insulating member (30) is made of the same material as for the current transformer CT (1) and the insulating member (30) tightly adheres to matching outer surfaces of the primary winding (24), column insulating body (28) and to the inner surface of the conductive encapsulation (26), and the elastic insulation member (15) tightly adheres to matching outer surfaces of the column insulating body (13), a winding shield (10) and to the inner surface of the conductive encapsulation (12), **characterized in that** the current transformer CT (1) has a head insulating body (7) having a form of a bushing for electrical insulation of the secondary winding assembly (5) from the primary winding conductor (6), the head insulating body (7) being placed within the conductive encapsulation (12) and being in contact with the insulating member (15), which insulating member (15) is made of an elastic conformable material which tightly adheres to matching outer surfaces of the head insulating body (7) of the current transformer CT (1) and the conductive encapsulation (12) of CT or the conductive encapsulation (26) of VT is made of electrically conductive polymer or electrically conductive elastomer material.

2. High-voltage instrument transformer according to claim 1, **characterized in that** the column (3) of CT or the column (34) of VT has a slit (18) or (35), respectively, which slit is filled with the insulating member (15) of CT or the insulating member (30) of VT, respectively.

3. High-voltage instrument transformer according to claims 1-2, **characterized in that** the winding shield (10) is made of metal or electrically conductive polymer or elastomer material.

4. High-voltage instrument transformer according to claim 1, **characterized in that** the elastic conformable material of the insulating member (15) of CT or the insulating member (30) of VT is a silicone elastomer or a gel chosen from silicone gel, polyurethane gel or urethane modified epoxy gel.

5. High-voltage instrument transformer according to claim 1, **characterized in that** the electrically conductive elastomer for the conductive encapsulation (12) of CT or the conductive encapsulation (26) of VT is a conductive silicone rubber.

6. High-voltage instrument transformer according to claim 1, **characterized in that** the winding shield (10) is made from metal, electrically conductive polymer material or electrically conductive elastomer material, preferably conductive silicone rubber.

7. High-voltage instrument transformer according to claims 1-6, **characterized in that** the head insulating body (7) and the column insulating body (13) of CT or the column insulating body (28) of VT, have a capacitive field grading system with field-grading layers (9), (14), (29) and in each field grading system the field-grading layers (9), (14), (29), respectively, are spaced from each other by insulating material made of paper impregnated with hardenable resin.

8. High-voltage instrument transformer according to claims 1-6, **characterized in that** head insulating body (7) and the column insulating body (13) of CT or the column insulating body (28) of VT have a capacitive field grading system with field-grading layers (9), (14), (29) and in each field grading system the field-grading layers (9), (14), (29), respectively, are spaced from each other by insulating material made of polymer fibers impregnated with hardenable resin.

9. High-voltage instrument transformer according to claim 8, **characterized in that** the hardenable resin comprises epoxy resin and an inorganic filler material.

10. High-voltage instrument transformer according to claims 1-9, **characterized in that** it has the external insulator (17) of CT or the external insulator (33) of VT which is made of a silicon elastomer directly molded on the column insulating body (13) of CT or the column insulating body (28) of VT, respectively.

11. High-voltage instrument transformer according to claims 2-8, **characterized in that** it has the external insulator (17) of CT or the external insulator (33) of VT which is provided with a stiff hollow cylinder (19) of CT or a stiff hollow cylinder (38) of VT, respectively, overmolded with weather sheds made of polymer or elastomer material.

12. High-voltage instrument transformer according to claims 2-8, **characterized in that** it has the external insulator (17) of CT or the external insulator (33) of VT which is made of porcelain material.

## Patentansprüche

1. Ein Hochspannungsinstrumententransformator in Form eines Stromwandlers CT (1) oder eines Spannungswandlers VT (21), wo der Stromwandler (1) mit elastischem Isolierungsmaterial (15) in der leitfähigen Verkapselung (12) mit einer Säule (3) ausgestattet ist, die einen Isolierkörper der Säule beinhaltet (13), welcher die elektrische Isolierung der Leitungen (4) der Sekundärwicklung (5) sicherstellt, und der Spannungswandler (21) mit elastischem Isolierungsmaterial (30) mit einer Säule (34) ausgestattet ist, die einen Isolierkörper der Säule beinhaltet (28), welcher die elektrische Isolierung der Leitungen (27) der Primärwicklung (24) sicherstellt, wobei der Isolierkörper der Säule (13) des Stromwandlers oder der Isolierkörper der Säule (28) des Spannungswandlers entsprechend an das elastische Isolierungsmaterial (15) des Stromwandlers oder das elastische Isolierungsmaterial (30) des Spannungswandlers anliegt, und die Säule (3) des Stromwandlers oder die Säule (34) des Spannungswandlers einen äußeren Isolator (17) des Stromwandlers oder einen äußeren Isolator (33) des Spannungswandlers hat und im Falle des Spannungswandlers (21) das Isolierungsmaterial (30) aus demselben Material wie im Falle des Isolierungsmaterials des Stromwandlers (1) gemacht ist und das Isolierungsmaterial (30) dicht an die entsprechenden äußeren Flächen der Primärwicklung (24), des Isolierkörpers der Säule (28) und der inneren leitfähigen Fläche der Verkapselung (26) anhaftet, und das elastische Isolierungsmaterial (15) dicht an die entsprechenden äußeren Flächen des Isolierkörpers der Säule (13), der Kernabdeckung (10) und der inneren leitfähigen Fläche der Verkapselung (12) anhaftet, **dadurch gekennzeichnet, dass** der Stromwandler (1) mit einem Isolierkörper des Kopfes (7) in Form einer Durchführung ausgestattet ist, die die elektrische Isolierung der Sekundärwicklung (5) von dem Leiter der Primärwicklung (6) sicherstellt, wobei der Isolierkörper des Kopfes (7) innerhalb der leitfähigen Verkapselung (12) platziert ist und an das Isolierungsmaterial (15) anliegt, welches aus elastischem, formanpassendem Material erzeugt ist, welches dicht an die entsprechenden äußeren Flächen des Isolierkörpers des Kopfes (7) des Stromwandlers CT (1) anliegt und die leitfähige Verkapselung (12) des Stromwandlers oder die leitfähige Verkapselung (26) des Spannungswandlers aus einem elektrisch leitfähigen Polymer oder einem elektrisch leitfähigen elastomeren Material erzeugt ist.

2. Der Hochspannungsinstrumententransformator nach Anspruch 1, **dadurch gekennzeichnet, dass** die Säule (3) des Stromwandlers oder die Säule (34) des Spannungswandlers entsprechend einen Schlitz (18) oder (35) hat, welcher entsprechend mit Isolierungsmaterial (15) des Stromwandlers oder Isolierungsmaterial (30) des Spannungswandlers gefüllt ist.

3. Der Hochspannungsinstrumententransformator nach Anspruch 1-2, **dadurch gekennzeichnet, dass** die Kernabdeckung (10) aus Metall oder aus einem elektrisch leitfähigen Polymer oder elastomeren Material erzeugt ist.

4. Der Hochspannungsinstrumententransformator nach Anspruch 1, **dadurch gekennzeichnet, dass** das elastische, formanpassende Material, aus welchem das Isolierungsmaterial (15) des Stromwandlers oder das Isolierungsmaterial (30) des Spannungswandlers hergestellt wird, ein Silikonelastomer oder entsprechend ein Silikon-, Polyurethan- oder mit Urethan modifiziertes Epoxidgel ist.

5. Der Hochspannungsinstrumententransformator nach Anspruch 1, **dadurch gekennzeichnet, dass** das elektrisch leitfähige Elastomer, aus welchem die leitfähige Verkapselung (12) des Stromwandlers oder die leitfähige Verkapselung (26) des Spannungswandlers hergestellt wird, ein elektrisch leitfähiges Silikongummi ist.

6. Der Hochspannungsinstrumententransformator nach Anspruch 1, **dadurch gekennzeichnet, dass** die Kernabdeckung (10) aus Metall oder aus einem elektrisch leitfähigen Polymer oder elastomeren Material vorzüglich aus leitfähigem Silikongummi erzeugt ist.

7. Der Hochspannungsinstrumententransformator nach Anspruch 1-6, **dadurch gekennzeichnet, dass** das Isolierkörper des Kopfes (7) und das Isolierkörper der Säule (13) des Stromwandlers oder das Isolierkörper der Säule (28) des Spannungswandlers ein System der kapazitiven Feldsteuerung mit Schichten (9), (14), (29) haben, die das Feld steuern, und in den entsprechenden Feldsteuerungssystemen entsprechend die Schichten (9), (14), (29) voneinander mit Isolierungsmaterial abgetrennt sind, welches aus dem mit härtbarem Harz imprägnierten Papier besteht.

8. Der Hochspannungsinstrumententransformator nach Anspruch 1-6, **dadurch gekennzeichnet, dass** das Isolierkörper des Kopfes (7) und das Isolierkörper der Säule (13) des Stromwandlers und das Isolierkörper der Säule (28) des Spannungswandlers ein System der kapazitiven Feldsteuerung mit Schichten (9), (14), (29) haben, die das Feld steuern, und in den entsprechenden Feldsteuerungssystemen entsprechend die Schichten (9), (14), (29) voneinander mit Isolierungsmaterial abgetrennt sind, welches aus den mit härtbarem Harz imprägnierten Polymerfasern besteht.

9. Der Hochspannungsinstrumententransformator nach Anspruch 8, **dadurch gekennzeichnet, dass** das härtbare Harz ein Epoxidharz sowie ein anorganisches Füllmaterial beinhaltet.

10. Der Hochspannungsinstrumententransformator nach Anspruch 1-9, **dadurch gekennzeichnet, dass** er den äußeren Isolator (17) des Stromwandlers oder den äußeren Isolator (33) des Spannungswandlers beinhaltet, der aus einem direkt entsprechend auf dem Isolierkörper der Säule (13) des Stromwandlers oder auf dem Isolierkörper der Säule (28) formierten Silikonelastomer besteht.

11. Der Hochspannungsinstrumententransformator nach Anspruch 2-8, **dadurch gekennzeichnet, dass** er mit dem äußeren Isolator (17) des Stromwandlers oder dem äußeren Isolator (33) des Spannungswandlers ausgestattet ist, der entsprechend einen steifen leeren Zylinder (19) des Stromwandlers oder einen steifen leeren Zylinder (38) des Spannungswandlers, geformt mit Flanschen, die aus Polymer oder einem elastomeren Material erzeugt werden.

12. Der Hochspannungsinstrumententransformator nach Anspruch 2-8, **dadurch gekennzeichnet, dass** er mit dem äußeren Isolator (17) des Stromwandlers oder dem äußeren Isolator (33) des Spannungswandlers ausgestattet ist, der aus Porzellan erzeugt wird.

## Revendications

1. Transformateur d'instrument de haute tension sous forme de transformateur de courant CT (1) ou de transformateur de tension VT (21) où le transformateur de courant (1), comprenant un matériau souple d'isolation (15) dans un boîtier conducteur (12), est muni d'une colonne (3) comportant un élément d'isolation de la colonne (13) pour assurer l'isolation électrique des bornes (4) de l'enroulement secondaire (5), alors que le transformateur de tension (21), comprenant un matériau souple d'isolation (30), est muni d'une colonne (34) comportant un élément d'isolation de la colonne (28) pour assurer l'isolation électrique des bornes (27) de son enroulement primaire (24), où l'élément d'isolation de la colonne (13) du transformateur de courant ou l'élément d'isolation de la colonne (28) du transformateur de tension adhère respectivement au matériau souple d'isolation (15) du transformateur de courant ou au matériau souple d'isolation de la colonne (30) du transformateur de tension, où la colonne (3) du transformateur de courant ou la colonne (34) du transformateur de tension possède un isolateur extérieur (17) du transformateur de courant ou un isolateur extérieur (33) du transformateur de tension, et que dans le cas du transformateur de tension (21) le matériau d'isolation (30) est fait du même matériau qu'en cas du transformateur de courant (1), et où le matériau d'isolation (30) adhère étroitement aux surfaces correspondantes extérieures de l'enroulement primaire (24), à l'élément d'isolation de la colonne (28) et à la surface intérieure du boîtier conducteur (26), et le matériau souple d'isolation (15) adhère étroitement aux surfaces correspondantes extérieures de l'élément d'isolation de la colonne (13), à la protection des noyaux (10) et à la surface intérieure du boîtier conducteur (12), **caractérisé en ce que** le transformateur de courant (1) possède un élément isolant de la tête (7) ayant la forme de traversée pour assurer l'isolation électrique du système d'enroulement secondaire (5) du conducteur de l'enroulement primaire (6), où l'élément isolant de la tête (7) est placé à l'intérieur du boîtier conducteur (12) et adhère au matériau d'isolation (15), lequel matériau d'isolation (15) est fabriqué de matériau souple qui adapte ses formes et qui adhère étroitement aux surfaces correspondantes extérieures de l'élément isolant de la tête (7) du transformateur de courant CT (1), et le boîtier conducteur (12) du transformateur de courant ou le boîtier conducteur (26) du transformateur de tension est fabriqué d'un polymère électro-conducteur ou d'un matériau élastomère électro-conducteur.

2. Transformateur d'instrument de haute tension selon la revendication 1, **caractérisé en ce que** la colonne (3) du transformateur de courant ou la colonne (34) du transformateur de tension possède respectivement une fente (18) ou une fente (35) laquelle fente est remplie d'un matériau d'isolation (15) du transformateur de courant ou de matériau d'isolation (30) du transformateur de tension.

3. Transformateur d'instrument de haute tension selon les revendications 1 et 2, **caractérisé en ce que** la protection du boîtier des noyaux (10) est fabriqué en métal ou en polymère électro-conducteur ou en matériau élastomère.

4. Transformateur d'instrument de haute tension selon la revendication 1, **caractérisé en ce que** le matériau souple qui adapte ses formes dont est fait l'élément d'isolation (15) du transformateur de courant ou le matériau d'isolation (30) du transformateur de tension est en élastomère silicone ou un gel, respectivement en silicone, en polyuréthane ou en époxyde, modifié à l'uréthane.

5. Transformateur d'instrument de haute tension selon la revendication 1, **caractérisé en ce que** l'élastomère électro-conducteur dont est fabriqué le boîtier conducteur (12) du transformateur de courant ou le boîtier conducteur (28) du transformateur de tension (26) est fabriqué en silicone gomme.

6. Transformateur d'instrument de haute tension selon la revendication 1, **caractérisé en ce que** la protection des noyaux (10) est fabriquée en métal, en polymère électro-conducteur ou en élastomère électro-conducteur, de préférence en silicone gomme.

7. Transformateur d'instrument de haute tension selon les revendications 1 à 6, **caractérisé en ce que** l'élément d'isolation de la tête (7) ainsi que l'élément d'isolation de la colonne (13) du transformateur de courant ou l'élément d'isolation de la colonne (28) du transformateur de tension possèdent un système capacitif de classement de champ par couches (9), (14), (29), classifiant le champ, et dans chaque système de classement de champ, les couches classifiant le champ (9), (14), (29) sont respectivement séparées les unes des autres par le matériau d'isolation fabriqué en papier imprégné avec de la résine durcissable.

8. Transformateur d'instrument de haute tension selon les revendications 1 à 6, **caractérisé en ce que** l'élément d'isolation de la tête (7) ainsi que l'élément d'isolation de la colonne (13) du transformateur de courant ou l'élément d'isolation de la colonne (28) du transformateur de tension possèdent un système capacitif de classement de champ par couches (9), (14), (29), classifiant le champ, et dans chaque système de classement de champ, les couches classifiant le champ (9), (14), (29) sont respectivement séparées les unes des autres par le matériau d'isolation fabriqué en fibres de polymère imprégnées avec de la résine durcissable.

9. Transformateur d'instrument de haute tension selon la revendication 8, **caractérisé en ce que** la résine durcissable comprend la résine époxyde et un matériau de remplissage minéral.

10. Transformateur d'instrument de haute tension selon les revendications 1 à 9, **caractérisé en ce qu'**il possède un isolateur extérieur (17) du transformateur de courant ou un isolateur extérieur (33) du transformateur de tension qui est fait en silicone élastomère moulé respectivement directement sur l'élément d'isolation de la colonne (13) du transformateur de tension ou sur l'élément d'isolation de la colonne (28) du transformateur de tension.

11. Transformateur d'instrument de haute tension selon les revendications 2 à 8, **caractérisé en ce qu'**il possède un isolateur extérieur (17) du transformateur de courant ou un isolateur extérieur (33) du transformateur de tension qui comprend respectivement un cylindre rigide vide (19) du transformateur de courant ou un cylindre rigide vide (38) du transformateur de tension, coulé avec un col fabriqué en polymère ou en matériau élastomère.

12. Transformateur d'instrument de haute tension selon les revendications 2 à 8, **caractérisé en ce qu'**il possède l'isolateur extérieur (17) du transformateur de courant ou l'isolateur extérieur (33) du transformateur de tension qui est fabriqué en porcelaine.
